Europäisches Patentamt

European Patent Office

Office européen des brevets

(19)

(11) Publication number: **0 112 111 B1**

## (12) EUROPEAN PATENT SPECIFICATION

(45) Date of publication of patent specification: **06.03.91**

(51) Int. Cl.⁵: **H01L 31/0224**, H01L 31/06

(21) Application number: **83307383.6**

(22) Date of filing: **05.12.83**

(54) **Solar cell.**

(30) Priority: **04.12.82 JP 213202/82**

(43) Date of publication of application:
**27.06.84 Bulletin 84/26**

(45) Publication of the grant of the patent:
**06.03.91 Bulletin 91/10**

(84) Designated Contracting States:
**DE FR GB IT**

(56) References cited:
**EP-A- 0 053 402**
**FR-A- 2 514 201**

**THIN SOLID FILMS, vol. 90, 1982, pages
297-308, Elsevier Sequoia, Lausanne, CH;
J.C. MANIFACIER: "Thin metallic oxides as
transparent conductors"**

**JOURNAL OF APPLIED PHYSICS, vol. 53, no.
3, March 1982, pages 1615-1621, American
Institute of Physics; E. SHANTHI et al.:
"Electrical and optical properties of tin oxide
films doped with F and (Sb + F)"**

**THIN SOLID FILMS, vol. 102, no. 1, April 1983,
pages 1-46, Lausanne, CH; K.L. CHOPRA et
al.: "Transparent conductors - A status re-**

**view"**

(73) Proprietor: **HOYA CORPORATION
13-12, 1-chome, Nishi-shinjuku
Shinjuku-ku Tokyo(JP)**

(72) Inventor: **Kawai, Hisao
13-12, 1-chome Nishi-shinjuku
Shinjuku-ku Tokyo(JP)**

(74) Representative: **Coleman, Stanley et al
MATHYS & SQUIRE 10 Fleet Street
London EC4Y 1AY(GB)**

## Description

Background to the Invention:

This invention relates to a solar cell for use in converting optical energy into electric energy.

A conventional solar cell of the type described comprises first and second members opposite to each other and an amorphous silicon lamina between the first and the second members. The first and the second members serve as electrodes. In such a solar cell, a predetermined one of the first and second members should be transparent in order to expose the amorphous silicon lamina to light and to generate electromotive force across the first and second members.

It is preferable that the solar cell has a high conversion efficiency of optical energy to electric energy. Most conventional attempts have been directed to improvement of characteristics of the amorphous silicon lamina so as to raise the conversion efficiency. In other words, the conventional attempts have left the first and the second members out of consideration. The conversion efficiency increases by improving characteristics of the amorphous silicon lamina to some extent. However, an increase of the conversion efficiency might reach a limit sooner or later in the above-mentioned manner. In addition, the conversion efficiency of each solar cell undesirably varies even when the amorphous silicon lamina is deposited on the same condition.

FR-A-2514201 published 8 April 1983 mentions, in the part of the description concerning the prior art, a solar cell comprising a transparent electrode formed of particles whose average size is less than 50nm.

Summary of the Invention:

It is an object of this invention to provide a solar cell which has an improved conversion efficiency.

It is another object of this invention to provide a solar cell of the type described, which is capable of reducing a variation of the conversion efficiency.

According to the present invention there is provided a solar cell including a first member, a second member opposite said first member, and an amorphous silicon lamina connected between said first and said second members, a predetermined one of said first and said second members comprising a transparent conductive layer of indium tin oxide which comprises an aggregation of particles having an average particle size between 30 and 90 nm said particles being distributed in said transparent conductive layer with a particle density which is not smaller than ten per square micrometer

Brief Description of the Drawings:

Fig. 1 shows a sectional view of a conventional solar cell;

Fig. 2 diagrammatically shows a sectional view of a solar cell according to a first embodiment of this invention;

Fig. 3 shows voltage versus current characteristics of the conventional solar cell and the solar cell illustrated in Fig. 2;

Fig. 4 shows a partial sectional view of the solar cell illustrated in Fig. 2; and

Fig. 5 shows a sectional view of a solar cell according to a second embodiment of this invention.

Description of the Preferred Embodiments:

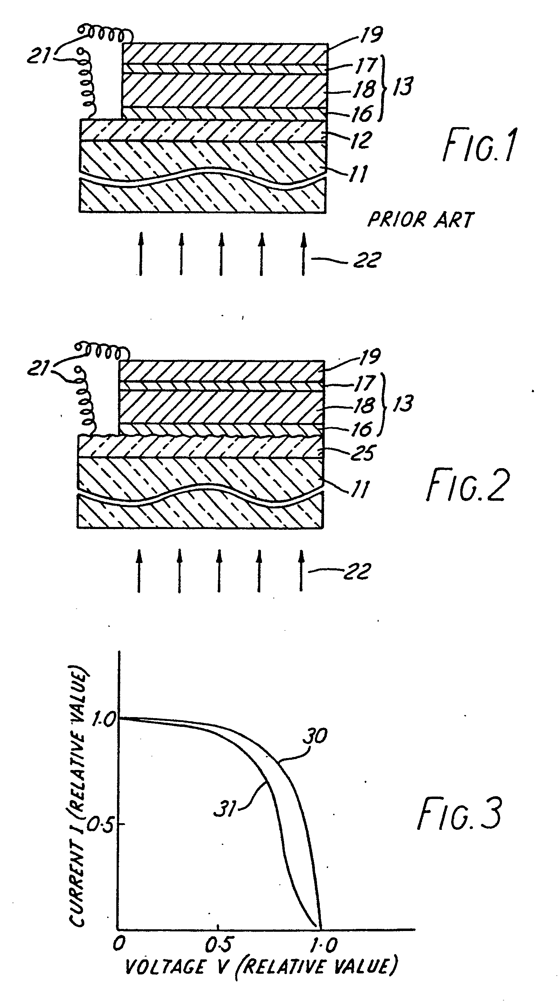

Referring to Fig. 1, a conventional solar cell will at first be described for a better understanding of this invention. The illustrated solar cell has a transparent substrate 11 of an insulator having first and second principal surfaces directed upwards and downwards of this figure, respectively. The transparent substrate 11 may be of soda-lime glass. A transparent conductive layer 12 is coated on the first principal surface of the substrate 11 and serves as an electrode of the solar cell. A combination of the substrate 11 and the transparent conductive layer 12 may be called a first member. The transparent conductive layer 12 may selectively be removed to form a pattern, if necessary.

An amorphous silicon lamina 13 is attached to the transparent conductive layer 12 and comprises a P-type amorphous silicon layer 16 brought into contact with the transparent conductive layer 12, an N-type amorphous silicon layer 17 opposite to the P-type silicon layer 16, and an intrinsic silicon layer 18 interposed between the amorphous silicon layers 16 and 17.

An aluminum layer 19 is deposited on the N-type silicon layer 17 and may be called a second member serving as another electrode of the solar cell. A pair of conductors 21 are derived from the first and the second members to be connected to a load (not shown).

In the illustrated example, the second principal surface of the substrate 11 is directed towards light indicated by arrows 22. As a result, the light 22 is incident onto the amorphous silicon lamina 13 through the transparent substrate 11 and the transparent conductive layer 12. The amorphous silicon lamina 13 is activated by the incidence of light to develop electromotive force across the transparent conductive layer 12 and the aluminum layer 19. The electromotive force is derived from the conductors 21 as electric power.

In order to improve a conversion efficiency of the solar cell, various kinds of improvements have been contemplated about the amorphous silicon lamina 13, as described in the preamble of the instant specification.

According to the inventor's experimental studies, it has been found out that the conversion efficiency is dependent not only on the amorphous silicon lamina 13 but also on the transparent conductive layer 12, as will become clear.

Referring to Fig. 2, a solar cell according to a first embodiment of this invention comprises similar parts designated by like reference numerals. The illustrated solar cell comprises a specific transparent conductive layer 25 which comprises tin-doped indium oxide, i.e. indium tin oxide. The illustrated indium tin oxide layer includes, by weight, 5% of tin oxide. The specific transparent conductive layer 25 is deposited to a thickness of 70nm (700 angstroms)by the use of vacuum evaporation and is formed by an aggregation of particles which have an average particle size not smaller than 30nm (300 angstroms). The vacuum evaporation is carried out with a pressure of oxygen and temperature of the substrate 11 kept at $10^{-4}$ Torr and $350°C$, respectively. A deposition rate is about 0.15nm/s (1.5 angstroms/second). The particles are crystals of the indium tin oxide. In order to determine the average particle size, the particles, namely, the crystals are at first observed through a scanning electron microscope. The particle size of each particle is defined by a maximum dimension of each particle. For example, a diameter, a transverse axis, and a diagonal are defined as the particle sizes when the particles are circular, elliptical, and rectangular, respectively. In order to obtain the average particle size, a calculation is made of the total number and total size of all those particles whose particle size is not smaller than 20nm (200 angstroms). Thereafter, the total size is divided by the total number. In other words, such calculation takes no account of the other particles smaller than 20nm (200 anstroms).

As a result of the above-mentioned calculation, the illustrated conductive layer 25 has an average particle size of 30nm (300 angstroms). A sheet resistance of the specific transparent conductive layer 25 is about 30 ohms/□.

The specific transparent conductive layer 25 has an undulated or uneven surface, as diagrammatically illustrated in Fig. 2 to an exaggerated degree, and serves as the first member.

As in Fig. 1, an amorphous silicon lamina 13 is deposited on the specific transparent conductive layer 25 by the use of a glowdischarge decomposition method known in the art. An aluminum layer 19 which serves as the second member is formed on the amorphous silicon lamina 13 by vacuum evaporation. The conductors 21 are connected to the first and the second members, respectively.

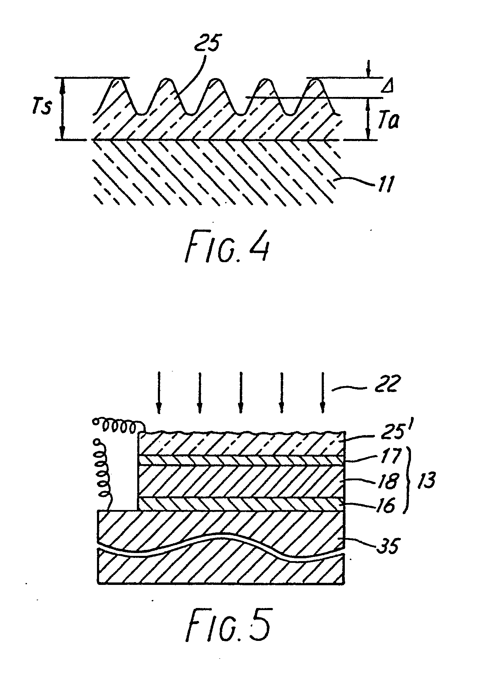

Referring to Fig. 3, a curve 30 shows a voltage versus current characteristic of the solar cell illustrated in conjunction with Fig. 2. On the other hand, a curve 31 shows a similar characteristic of a reference solar cell as illustrated in Fig. 1. The reference solar cell comprises the indium tin oxide layer having the average particle size smaller than 20nm (200 angstroms). Specifically, the indium tin oxide layer in the reference solar cell comprises particles most of which are smaller than 20nm (200 angstroms) and which never exceed 30nm (300 angstroms).

Each characteristic is measured by exposing each of the solar cells to light of AM1 (Air Mass 1).

In Fig. 3, let consideration be directed to a partial derivative of V with respect to I, where V and I represent the voltage and current shown along the abscissa and the ordinate of Fig. 3, respectively. As known in the art, it is possible to estimate an absolute value of the partial derivative calculated at $I = 0$. More particularly, the smaller the absolute value, the better is the characteristic of a solar cell. Under the circumstances, it is readily understood that the solar cell according to the first embodiment of this invention is remarkably smaller in the absolute value than the reference solar cell and, therefore, has an excellent characteristic in comparison with the conventional one. This means that the conversion efficiency is improved in the solar cell illustrated in Fig. 2 because a reduction of the absolute value contributes to a decrease of an internal resistance and, therefore, to an improvement of a fill factor.

Practically, the fill factor and the conversion efficiency of the solar cell according to this invention are improved by about 20% and 20% as compared with those of the conventional solar cell, respectively. This is because a contact area increases between the amorphous silicon lamina 13 and the specific or undulated transparent conductive layer 25. As a result, an electrical contact between them is improved with this structure. In other words, the undulated conductive layer 25 serves to protect the light from being scattered from the amorphous silicon lamina 13. The light is therefore effectively utilized to excite the amorphous silicon lamina 13.

In order to confirm or establish the relationship between the average particle size of the indium tin oxide and the voltage versus current characteristic, various samples were manufactured in the above-mentioned manner. When the samples had the average particle size of the indium tin oxide layer which was less than 30nm (300 angstroms). their voltage versus current characteristics were substantially identical to the curve 31. When the average particle size exceeded 30nm (300 angstroms), the characteristics approached the curve 30. From this fact, it has been contemplated that the average particle size of the indium tin oxide layer should not be smaller than 30nm (300 angstroms) so as to improve the conversion factor in the solar cell. According to the inventor's experimental studies, an average particle size is adjustable by controlling the pressure of oxygen and the deposition rate with the substrate 11 kept at 350° C. For example, an average particle size of 35nm (350 angstroms) can be obtained under a pressure of $266.10^{-4}$ Pa ($2 \times 10^{-4}$ Torr) and a deposition rate of 0.1nm/s of (1 angstrom/second) while an average particle size of 80nm of (800 angstroms) is attained under a pressure of $133.10^{-4}$ Pa $10^{-4}$ Torr) and a disposition rate of 0.05nm/s of (0.5 angstrom/second).

Examination has been made to clarify the relationship between the conversion efficiency and the number of particles included in each sample. As a result, it has been found that at least ten of the particles may be present per square $\mu$m . Preferably, not less than one hundred particles may exist per square $\mu$m. As mentioned before, each particle is not smaller than 20nm (200 angstroms).

Referring to Fig. 4, a particular factor $\Delta$ has been introduced soas to determine an upper limit of the average particle size. As shown in Fig. 4, the specific transparent conductive layer 25 undulates on a surface thereof and has therefore projections and notches on the surface. It is assumed that the thickness of the specific transparent conductive layer 25 is measured by the use of the usual thickness gauge of the probe type. In this event, the probe cannot be introduced into the notches and is in contact only with the projections because the probe is thicker than the width between the projections. As a result, the measured thickness specifies each height of the projections which is denoted by Ts. On the other hand, an average thickness Ta can be optically measured in a known manner. The above-mentioned particular factor $\Delta$ is defined by a difference between the thickness Ts of each projection and the average thickness Ta and may be called a difference factor. When the difference factor has been between 10 and 65nm (100 and 650 angstroms), about 6% of the conversion efficiency has been accomplished and practically utilized as a solar cell. In addition, it has been found that the difference factors $\Delta$ of 10 and 65nm (100 and 650 angstroms)correspond to the average particle sizes of about 30 and 90nm (300 and 900 angstroms), respectively. In this connection, the average particle size is preferably not larger than 90nm (900 angstroms).

Referring to Fig. 5, a solar cell according to a second embodiment of this invention comprises, as the first electrode member, a conductive substrate 35 of a metal, such as stainless steel or the like. A specific transparent conductive layer 25' which is similar to that illustrated in conjunction with Fig. 2 is attached to the amorphous silicon lamina 13. The amorphous silicon lamina I3 is identical with that shown in Fig. 2. The specific transparent conductive layer 25' may be of indium tin oxide like in Fig. 2 and comprises an aggregation of particles which are not smaller in particle size than 30nm (300 angstroms). In this solar cell, the transparent conductive layer 25' serves as the second member and is directed towards light 22, as shown in Fig. 5.

With this structure also, the conversion efficiency has been improved when the average particle size is between 30 and 90nm 300 and 900 angstroms), as is the case with Fig. 2.

Although the vacuum evaporation is used to deposit the specific transparent conductive layer 25 or 25' in the first and the second embodiments, a radio frequency (RF) reactive ion plating method may be carried out instead of the vacuum evaporation. In this event, it has been found out that the average particle size tends to increase with a reduction of RF power. For example, the average particle sizes became substantially equal to 30, 50 and 80nm (300,500, and 800 angstroms) when the RF power was adjusted to 300, 200, and 100 watts, respectively, on condition that the substrate 11 or 35, the pressure of oxygen, and the deposition rate were kept at 300° C, $133.10^{-4}$ Pa ($1 \times 10^{-4}$ Torr), and 0.3nm/s (3 angstroms/second), respectively.

It is also possible to control the average particle size of the indium tin oxide by varying the pressure of oxygen and/or the deposition rate.

While this invention has thus far been described in conjunction with a few embodiments thereof, it will readily be possible for those skilled in the art to put this invention into practice in various manners. For example, various evaporation methods, such as a d.c. ion plating method, an activated reactive method, or the like may be employed to deposit the specific transparent conductive layer.

## Claims

1. A solar cell including a first member, a second member opposite said first member, and an amorphous silicon lamina connected between said first and said second members, a predetermined one of said first and said second members comprising a transparent conductive layer of indium tin oxide which comprises an aggregation of particles having an average particle size between 30 and 90 nm said particles being distributed in said transparent conductive layer with a particle density which is not smaller than ten per square micrometer.

2. A solar cell as claimed in Claim 1, wherein said particle density is higher than 100 per square micrometer.

3. A solar cell as claimed in Claim 1 or 2, wherein said first member is said predetermined one of the first and the second members and comprises a transparent insulator substrate and said transparent conductive layer attached to said amorphous silicon lamina.

4. A solar cell as claimed in Claim 1 or 2, wherein said second member is said predetermined one of the first and the second members and is formed by said transparent conductive layer overlaid on said amorphous silicon lamina.

## Revendications

1. Cellule solaire comprenant un premier élément, un second élément opposé au premier élément, et une lame stratifiée de silicium amorphe montée entre ces premier et second éléments, l'un, prédéterminé, des premier et second éléments étant constitué par Une couche conductrice transparente d'oxyde d'indium à l'étain comprenant une agrégation de particules présentant une taille de particules moyenne comprise entre 30 et 90 nm, ces particules étant réparties dans la couche conductrice transparente avec une densité de particules ne descendant pas au-dessous de 10 par micromètre carré.

2. Cellule solaire selon la revendication 1, caractérisée en ce que la densité de particules est supérieure à 100 par micromètre carré.

3. Cellule solaire selon l'une quelconque des revendications 1 et 2, caractérisée en ce que le premier élément est celui, prédéterminé, des premier et second éléments et consiste en un substrat isolant transparent, et en ce que la couche conductrice transparente est fixée à la lame stratifiée de silicium amorphe.

4. Cellule solaire selon l'une quelconque des revendications 1 et 2, caractérisée en ce que le second élément est celui, prédéterminé, des premier et second éléments, et se trouve formé par la couche conductrice transparente déposée sur la lame stratifiée de silicium amorphe.

## Ansprüche

1. Solarzelle mit einem ersten Element, einem dem ersten Element gegenüberliegenden zweiten Element und einer zwischen dem ersten und dem zweiten Element liegenden Schicht aus amorphem Silizium, wobei ein vorgegebenes Element der beiden Elemente eine durchsichtige, leitende Schicht aus Indium-Zinn-Oxid aufweist, die eine Aggregation von Teilchen mit einer mittleren Teilchengröße von 30 bis 90 nm aufweist und wobei die Teilchen in der durchsichtigen, leitenden Schicht mit einer Teilchendichte verteilt sind, die nicht kleiner ist als 10 $\mu m^{-2}$.

2. Solarzelle nach Anspruch 1, wobei die Teilchendichte größer ist als 100 $\mu m^{-2}$.

3. Solarzelle nach Anspruch 1 oder 2, wobei das erste Element das vorgegebene Element aus den beiden Elementen ist und ein durchsichtiges Isolatorsubstrat sowie die durchsichtige, leitende Schicht aufweist, die an der Schicht aus amorphem Silizium befestigt ist.

4. Solarzelle nach Anspruch 1 oder 2, wobei das zweite Element das vorgegebene Element der beiden Elemente ist und durch die durchsichtige, leitende Schicht gebildet wird, die auf der Schicht aus amorphem Silizium liegt.

FIG.1

PRIOR ART

FIG.2

FIG.3

FIG. 4

FIG. 5